# FASCICULE DE BREVET EUROPEEN

(11) **EP 0 564 367 B1**
(45) Date de publication et mention de la délivrance du brevet: **14.06.1995**
(21) Numéro de dépôt: 93400860.8
(22) Date de dépôt: 02.04.1993
(51) Int. Cl.: H01S 3/133, H04B 10/00

(54) **Circuit d'asservissement de la puissance modulée émise par un laser semiconducteur**
Steuerungsschaltkreis für einen amplitudenmodulierten Halbleiterlaser
Control circuit for an amplitude-modulated semiconductor laser

(30) Priorité: 03.04.1992 FR 9204086
(43) Date de publication de la demande: 06.10.1993
(73) Titulaire: THOMSON HYBRIDES, 92800 Puteaux (FR)
(72) Inventeur: Lamache, Philippe, F-92402 Courbevoie Cedex (FR); Landre, Michel, F-92402 Courbevoie Cedex (FR)
(74) Mandataire: Guérin, Michel

(56) Documents cités:
- EP-A- 0 237 922
- GB-A- 1 539 624
- PATENT ABSTRACTS OF JAPAN vol. 11, no. 387 (E-566)17 Décembre 1987 & JP-A-62 151 039
- CONFERENCE PROCEEDINGS OF THE THIRD EUROPEAN CONFERENCE ON OPTICAL COMMUNICATION,SEPTEMBRE 14-16, 1977, MUNICH, RFA pages 208 - 210;S.R SALTER ET AL: 'Laser automatic level control circuits for optical communications systems'
- PATENT ABSTRACTS OF JAPAN vol. 13, no. 338 (E-795)28 Juillet 1989 & JP-A-01 098 284

## Description

La présente invention concerne un circuit d'asservissement du signal émis par un laser semiconducteur. Ce signal comprend une puissance moyenne émise, à laquelle est superposée une modulation qui constitue le signal transmis: le circuit selon l'invention représente une simplification par rapport aux circuits connus de régulation de la puissance émise par le laser.

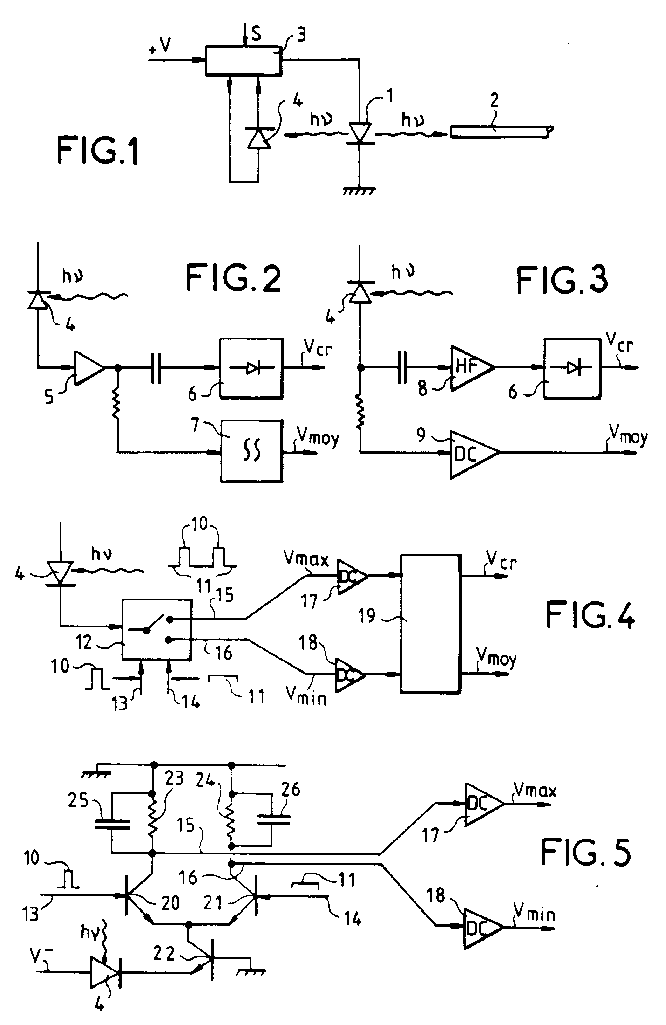

Le schéma général d'un module ou tête optique à laser semiconducteur est représenté en figure 1. Une diode laser 1 émet un signal optique hν, par une première face, en direction d'une fibre optique 2. Ce signal optique est généré grâce à une alimentation 3 qui reçoit d'une part une tension V continue, nécessaire pour que le laser émette un faisceau de lumière cohérente, et d'autre part un signal S qui constitue le message à transmettre, analogique ou logique. Mais le courant qui traverse le laser 1 est asservi par l'alimentation 3, qui comprend une photodiode 4 d'asservissement : cette photodiode est disposée en face de la seconde face du laser 1, et elle est éclairée par le faisceau arrière du laser. Elle reçoit donc comme la fibre optique 2, un faisceau lumineux qui comprend une composante continue à laquelle est superposée une composante de signal, logique ou analogique. Le signal à transmettre est à priori à haute fréquence, en microondes, parce qu'on n'utilise pas des fibres optiques pour transmettre des signaux en basse fréquence, jusqu'à quelques mégahertz : il existe pour cela des solutions beaucoup plus simples.

La photodiode d'asservissement 4 ne constitue qu'un capteur d'information, et pour pouvoir asservir le laser 1 il faut amplifier cette information fournie par la photodiode 4. Si l'on n'utilise qu'un seul amplificateur, il doit avoir un produit gain-bande élevé : de tels amplificateurs ont un décalage ou offset en tension important et cet offset est sensible à la température. Si l'on utilise un amplificateur pour la valeur moyenne du signal et un amplificateur pour la composante modulée du signal, il est difficile d'équilibrer les deux chaines d'amplifications.

Le circuit selon l'invention comporte un commutateur en série avec la diode d'asservissement. Ce commutateur est commandé par le signal appliqué sur le laser, appelé signal modulant, et par le signal modulant inverse, de sorte qu'une voie de commutateur délivre une tension correspondant à la puissance maximale du signal, et l'autre voie délivre une tension correspondant à la puissance minimale du signal. Ces deux tensions continues sont aisément amplifiées par des amplificateurs simples. A partir de ces deux tensions, il est facile de calculer les informations de puissance moyenne et de taux de modulation.

De façon plus précise, l'invention concerne un circuit d'asservissement de la puissance modulée émise par un laser semiconducteur au moyen d'une photodiode de contre-réaction qui, par un étage d'amplification, asservit l'alimentation du laser, ce circuit étant caractérisé en ce que, entre la photodiode et l'étage d'amplification, il comporte un commutateur à deux sorties et à deux entrées de commande dont la première reçoit le signal modulant appliqué sur le laser et dont la deuxième reçoit un signal modulant inverse du signal précédent, de sorte qu'une sortie du commutateur délivre une tension correspondant à la puissance maxima (Vₘₐₓ) émise par le laser, et l'autre sortie délivre une tension correspondant à la puissance minima émise par le laser.

Le procédé d'asservissement selon l'invention est défini dans la revendication 6. Différents modes particuliers de réalisation de cette invention sont décrits dans les revendications dépendantes.

L'invention sera mieux comprise par la description qui suit d'un exemple d'application, en s'appuyant sur les figures jointes en annexe, qui représentent :
- figure 1 : plan général d'asservissement d'une diode laser, exposé précédemment,
- figures 2 et 3 : circuits électriques de deux solutions connues d'asservissement,
- figure 4 : circuit électrique, en diagramme de blocs, de la solution d'asservissement selon l'invention,
- figure 5 : schéma détaillé du commutateur utilisé dans le circuit selon l'invention.

Le rappel, dans les figures 2 et 3, de deux circuits d'asservissement connus permettra de mieux faire ressortir la différence du circuit selon l'invention.

Pour l'ensemble des figures 2 à 5 ne sont représentés que la diode d'asservissement ou de contre-réaction 4 et les composants d'amplification du signal fourni par cette diode; la diode laser 1 et le circuit d'asservissement, qui fait partie de l'alimentation 3, ne sont pas représentés.

En figure 2, la composante continue et la composante alternative du signal émis par la photodiode 4 sont amplifiées simultanément par l'amplificateur 5. Celui-ci doit donc possèder une bande passante allant du continu jusqu'à la fréquence maxima du signal transmis par le laser 1. A la sortie de cet amplificateur 5, un filtre partage le signal entre :
- un circuit de détection 6, simple ou double alternance, qui restitue une image de l'information alternative, c'est à dire qui fournit les niveaux crête-crête V_{cr},
- un intégrateur 7, qui extrait la valeur moyenne du signal V_{moy}.

En fait, un amplificateur à large bande passante tel que l'amplificateur 5 possède généralement une tension de décalage entrée-sortie, dite offset, qui est importante. Cet offset est sensible aux variations de température, entraînant un décalage de zéro, instable en température. Si la valeur moyenne V_{moy} du signal amplifié n'est pas stable, il n'est pas possible de l'utiliser en conjonction avec la composante alternative, c'est à dire avec la valeur crête-crête V_{cr}.

C'est pourquoi il est connu d'amplifier séparément, comme représenté en figure 3. Un filtre RC placé à proximité de la photodiode 4 oriente la composante alternative vers un amplificateur 8 à large bande passante, qui fournit V_{cr}, tandis qu'un amplificateur continu 9 traite l'ensemble du signal et en fournit la valeur moyenne V_{moy}.

Dans ce second schéma, la valeur moyenne V_{moy} du signal est stable parce qu'elle est fournie par un amplificateur continu 9 stable en température, mais il reste un amplificateur HF 8 dont il faut maintenir constant en température le gain HF. De plus, il faut calibrer en température deux chaines d'amplification différentes, l'une continue, l'autre HF.

Le fondement du circuit selon l'invention permet d'éviter les inconvénients de la dérive en température des amplificateurs large bande, ou ceux de la calibration de deux chaînes d'amplification, dont l'une est HF et l'autre est continue. Selon l'invention le courant issu de la photodiode de contre-réaction 4 est traité pour en extraire deux courants continus représentatifs de la puissance maxima et de la puissance minima émise par le laser 1 : par traitement simple (addition, soustraction) de ces deux valeurs continues, on en tire la valeur moyenne 1/2 (Vₘₐₓ + Vₘᵢₙ) et le taux de modulation ou tension crête-crête Vₘₐₓ - Vₘᵢₙ. Seuls interviennent pour amplifier des amplificateurs continus, qui n'ont pas les inconvénients des amplificateurs HF. Le commutateur qui sélectionne les deux courants continus est représenté en figure 4 et détaillé en figure 5.

La photodiode de contre-réaction 4 est illuminée par le faisceau arrière du laser 1. Ce faisceau, symbolisé par sa quantification hν, est composé d'un fond continu de lumière cohérente, modulé par le signal à transmettre. Supposons, pour simplifier l'exposé, que ce signal à transmettre soit de type logique, ou numérique : la forme de ce signal est représentée en figure 4 à droite de la photodiode. Elle comprend une première pluralité de crêtes 10 qui correspondent à la puissance maxima des impulsions transmises, et une deuxième pluralité de crêtes 11 qui correspondent à la puissance minima. En régime numérique, toutes les impulsions ont la même valeur, et l'ensemble des crêtes 10 est équivalent à un quasi-courant continu, de même que l'ensemble des crêtes 11 est équivalent à un autre quasi-courant continu.

Le commutateur 12 a pour fonction de séparer ces deux courants de crêtes, pour ensuite les traiter séparément. Il reçoit sur son unique entrée le courant issu de la photodiode de contre-réaction 4, et délivre sur chacune de ses deux sorties l'un des deux courants de crêtes. La commutation est contrôlée par deux entrées de commande 13 et 14, dont l'une reçoit le signal modulant et l'autre reçoit le signal modulant inverse. A titre d'exemple non limitatif, l'entrée de commande 13 reçoit le signal modulant 10 et oriente le courant crête maximum vers la sortie 15, et l'entrée de commande 14 reçoit le signal modulant inverse 11 et oriente le courant crête minimum vers la sortie 16.

Deux amplificateurs 17 et 18 identiques, à courants continus, amplifient ces deux courants crêtes et délivrent Vₘₐₓ pour l'un et Vₘᵢₙ pour l'autre. La chaine de traitement 19 fournit la valeur moyenne V_{moy} par addition et le taux de modulation V_{cr} par soustraction. Le schéma électrique du circuit 19 est connu.

La figure 5 donne le schéma plus détaillé du commutateur 12. Il est essentiellement constitué par une paire différentielle de transistors 20 et 21, de type unipolaire ou bipolaire, NPN ou PNP. Un transistor 22, placé à l'entrée du commutateur, abaisse l'impédance d'entrée vue par la photodiode 4, ce qui augmente la bande passante du commutateur. Deux résistances 23 et 24, d'une valeur comprise entre 1 et 100 kilo-ohms, montées en série avec les transistors 20 et 21, transforment le courant de la photodiode 4 en un signal de sortie Vₘₐₓ ou Vₘᵢₙ, recueilli sur les sorties 15 et 16 aux points communs entre les résistances 23-24 et les transistors 20-21. Deux capacités 25 et 26, en parallèle sur les résistances 23 et 24, intègrent les signaux de sorties, entre deux impulsions.

Sur l'électrode de commande - base ou grille - de l'un des transistors de la paire différentielle est appliqué le signal modulant le laser 1 : par exemple sur le transistor 20. Dans ce cas, le signal modulant inverse est appliqué sur le transistor 21. Le circuit d'inversion n'est pas représenté, mais il est connu qu'un simple transistor suffit à cette fonction. Selon la nature des transistors 20 et 21, si le signal de crête 10 rend conducteur le transistor 20, au même moment le signal inversé de la crête 10 bloque le transistor 21 : la sortie 15 délivre un signal Vₘₐₓ, et la sortie 16 est bloquée. A l'instant suivant, le signal inversé de la crête 11 rend conducteur le transistor 21, tandis que le signal de crête 11 bloque le transistor 20 : la sortie 16 délivre un signal Vₘᵢₙ et la sortie 15 est bloquée.

Une autre façon d'obtenir un fonctionnement alterné de la paire différentielle est de maintenir l'électrode de commande de l'un des deux transistors 21 par exemple, polarisée par une tension fixe, qui peut être la masse, et d'appliquer sur l'électrode de commande de l'autre transistor 20 le signal ± S modulant le laser.

Ce circuit d'asservissement fonctionne de la même façon si le signal transmis par le laser 1 est analogique : les deux transistors 20 et 21 conduisent alternativement, et ils commutent en un point du signal analogique qui est fonction de leurs caractéristiques propres, telle que la tension de seuil par exemple. La commutation peut être moins franche qu'en numérique, dans les cas où le signal analogique est relativement plat et proche de sa valeur moyenne, le signal modulant et son inverse ont alors la même valeur, à peu de chose près.

Néanmoins, dans le cas d'une transmission numérique, la sensibilité en température est minime, et il n'y a pas de problème d'offset. Les deux voies sont identiques et les composantes V_{cr} et V_{moy} sont élaborées à partir de Vₘₐₓ et Vₘᵢₙ qui sont stables. En outre, la structure de l'étage permet une bande passante élevée, par absence d'effet Miller, et enfin l'utilisation de deux tensions continues, en sortie, rend plus aisé l'asservissement d'un laser.

Application aux télécommunications et aux transmissions de données sur fibre optique.

## Revendications

1. Circuit d'asservissement de la puissance modulée émise par un laser semiconducteur (1) au moyen d'une photodiode (4) de contre-réaction qui, par un étage d'amplification (17, 18), asservit l'alimentation (3) du laser (1), ce circuit étant caractérisé en ce que, entre la photodiode (4) et l'étage d'amplification (17, 18), il comporte un commutateur (12) à deux sorties (15,16) et à deux entrées de commande (13,14) dont la première (13) reçoit le signal (10) modulant appliqué sur le laser et dont la deuxième (14) reçoit un signal (11) modulant inverse du signal précédent (10), de sorte qu'une sortie (15) du commutateur (12) délivre une tension correspondant à la puissance maxima (Vₘₐₓ) émise par le laser (1), et l'autre sortie (16) délivre une tension correspondant à la puissance minima (Vₘᵢₙ) émise par le laser.

2. Circuit d'asservissement selon la revendication 1, caractérisé en ce que l'entrée du commutateur (12) est réunie à la photodiode (4), et chacune des deux sorties (15,16) est réunie à un amplificateur à courant continu (17, 18).

3. Circuit d'asservissement selon la revendication 2, caractérisé en ce que le signal modulant (10) appliqué sur la première entrée de commande (13) du commutateur (12) oriente la puissance maxima (Vₘₐₓ) vers un premier amplificateur (17), et en ce que le signal modulant inverse (11) appliqué sur la deuxième entrée de commande (14) oriente la puissance minima (Vₘᵢₙ) vers un deuxième amplificateur (18).

4. Circuit d'asservissement selon la revendication 1, caractérisé en ce que le commutateur (12) est constitué par une paire différentielle de transistors (20, 21), montés en série avec une résistance (23, 24) et une capacité d'intégration (25, 26), les dits transistors (20, 21) étant parcourus par le courant de la photodiode (4) et alternativement rendus conducteurs ou bloqués par le signal modulant (10) ou le signal modulant inverse (11) appliqué sur leur électrode de commande, les deux sorties (15, 16) du commutateur étant prélevées aux points communs entre les deux résistances (23,24) et les deux transistors.

5. Circuit selon la revendication 4, caractérisé en ce qu'un troisième transistor (22) est monté entre la photodiode (4) et la paire différentielle (20, 21), afin d'adapter l'impédance d'entrée du commutateur et d'augmenter sa bande passante.

6. Procédé d'asservissement de la puissance émise par un laser semiconducteur (1) et modulée par un signal modulant, l'asservissement étant obtenu au moyen d'une photodiode (4) de contre-réaction illuminée par le faisceau arrière du laser (1), ce procédé étant caractérisé en ce que le courant de la photodiode est commuté à la fréquence du signal modulant (10, 11), afin d'en sélectionner la puissance maxima (Vₘₐₓ) et la puissance minima (Vₘᵢₙ), à partir desquelles sont calculées la puissance moyenne (V_{moy}) et le taux de modulation (Vₘₐₓ - Vₘᵢₙ).

7. Procédé d'asservissement selon la revendication 6, caractérisé en ce que les courants commutés (Vₘₐₓ, V ₘᵢₙ) en sortie du commutateur (12) sont des courants quasi-continus, amplifiés par deux amplificateurs à courant continu identiques.

## Patentansprüche

1. Schaltung zur Regelung der von einem Halbleiterlaser (1) ausgesendeten modulierten Leistung mit Hilfe einer Gegenkopplungs-Fotodiode (4), die über eine Verstärkungsstufe (17, 18) die Speisung (3) des Lasers (1) nachregelt, dadurch gekennzeichnet, daß zwischen der Fotodiode (4) und der Verstärkungsstufe (17, 18) ein Schalter (12) mit zwei Ausgängen (15, 16) und zwei Steuereingängen (13, 14) vorgesehen ist, wobei der erste Steuereingang (13) das an den Laser angelegte modulierende Signal (10) und der zweite (14) ein zum vorhergehenden Signal (10) inverses modulierendes Signal (11) empfängt, so daß ein Ausgang (15) des Schalters (12) eine Spannung entsprechend der maximalen Sendeleistung (Vₘₐₓ) des Lasers (1) und der andere Ausgang (16) eine Spannung entsprechend der minimalen Sendeleistung (Vₘᵢₙ) des Lasers liefert.

2. Regelschaltung nach Anspruch 1, dadurch gekennzeichnet, daß der Eingang des Schalters (12) an die Fotodiode (4) angeschlossen ist und daß jeder der beiden Ausgänge (15, 16) mit einem Gleichstromverstärker (17, 18) verbunden ist.

3. Regelschaltung nach Anspruch 2, dadurch gekennzeichnet, daß das modulierende Signal (10), das an den ersten Steuereingang (13) des Schalters (12) angelegt ist, das Signal betreffend die Maximalleistung (Vₘₐₓ) an einen ersten Verstärker (17) lenkt, und daß das inverse modulierende Signal (11), das an den zweiten Steuereingang (14) angelegt ist, das Signal betreffend die Minimalleistung (Vₘᵢₙ) an einen zweiten Verstärker (18) lenkt.

4. Regelschaltung nach Anspruch 1, dadurch gekennzeichnet, daß der Schalter (12) aus einem Differentialpaar von Transistoren (20, 21) besteht, die in Reihe mit einem Widerstand (23, 24) und einem Integrationskondensator (25, 26) geschaltet sind, wobei diese Transistoren (20, 21) vom Strom der Fotodiode (4) durchflossen werden und abwechselnd von dem an ihre Steuerelektrode angelegten modulierenden Signal (10) oder dem inversen modulierende Signal (11) in Leitrichtung oder Sperrichtung gesteuert werden, wobei die beiden Ausgänge (15, 16) des Schalters an den gemeinsamen Punkten zwischen den beiden Widerstände (23, 24) und den beiden Transistoren entnommen werden.

5. Regelschaltung nach Anspruch 4, dadurch gekennzeichnet, daß ein dritter Transistor (22) zwischen die Fotodiode (4) und das Differentialpaar von Transistoren (20, 21) eingefügt ist, um die Eingangsimpedanz des Schalters anzupassen und sein Frequenzband zu verbreitern.

6. Verfahren zur Regelung der von einem Halbleiterlaser (1) ausgesendeten Leistung, die von einem modulierenden Signal moduliert wird, wobei die Regelung mit Hilfe einer Gegenkopplungs-Fotodiode (4) erzielt wird, die vom rückwärtigen Strahl des Lasers (1) beleuchtet wird, dadurch gekennzeichnet, daß der Strom der Fotodiode mit der Frequenz des modulierenden Signals (10, 11) umgeschaltet wird, um daraus ein Signal betreffend die Maximalleistung (Vₘₐₓ) und ein Signal betreffend die Mindestleistung (Vₘᵢₙ) auszuwählen, wobei ausgehend von diesen Signalen die mittlere Leistung (V_{moy}) und der Modulationsgrad (Vₘₐₓ - Vₘᵢₙ) berechnet werden.

7. Regelverfahren nach Anspruch 6, dadurch gekennzeichnet, daß die am Ausgang des Schalters (12) vorliegenden geschalteten Ströme (Vₘₐₓ, Vₘᵢₙ) praktisch Gleichströme sind, die von zwei identischen Gleichstromverstärkern verstärkt werden.

## Claims

1. Circuit for slaving the modulated power emitted by a semiconductor laser (1) by means of a feedback photodiode (4) which, via an amplification stage (17, 18), slaves the power supply (3) of the laser (1), this circuit being characterized in that, between the photodiode (4) and the amplification stage (17, 18), it includes a switch (12) with two outputs (15, 16) and with two control inputs (13, 14), the first (13) of which receives the modulating signal (10) applied to the laser and the second (14) of which receives a modulating signal (11) which is the inverse of the preceding signal (10), so that one output (15) of the switch (12) delivers a voltage corresponding to the maximum power (Vₘₐₓ) emitted by the laser (1) and the other output (16) delivers a voltage corresponding to the minimum power (Vₘᵢₙ) emitted by the laser.

2. Slaving circuit according to Claim 1, characterized in that the input of the switch (12) is connected to the photodiode (4), and each of the two outputs (15, 16) is connected to a direct-current amplifier (17, 18).

3. Slaving circuit according to Claim 2, characterized in that the modulating signal (10) applied to the first control input (13) of the switch (12) orients the maximum power (Vₘₐₓ) towards a first amplifier (17), and in that the inverse modulating signal (11) applied to the second control input (14) orients the minimum power (Vₘᵢₙ) towards a second amplifier (18).

4. Slaving circuit according to Claim 1, characterized in that the switch (12) consists of a differential transistor pair (20, 21), mounted in series with a resistor (23, 24) and an integration capacitor (25, 26), the said transistors (20, 21) carrying the current of the photodiode (4) and being turned on or off alternately by the modulating signal (10) or the inverse modulating signal (11) applied to their control electrode, the two outputs (15, 16) of the switch being picked up at the common points between the two resistors (23, 24) and the two transistors.

5. Circuit according to Claim 4, characterized in that a third transistor (22) is mounted between the photodiode (4) and the differential pair (20, 21), so as to match the input impedance of the switch and to increase its passband.

6. Method of slaving the power emitted by a semiconductor laser (1) and modulated by a modulating signal, the slaving being achieved by means of a feedback photodiode (4) illuminated by the rear beam from the laser (1), this method being characterized in that the current of the photodiode is switched at the frequency of the modulating signal (10, 11), so as to select the maximum power (Vₘₐₓ) and the minimum power (Vₘᵢₙ) therefrom, from which the mean power (V_{moy}) and the modulation ratio (Vₘₐₓ - Vₘᵢₙ) are calculated.

7. Slaving method according to Claim 6, characterized in that the switched currents (Vₘₐₓ, Vₘᵢₙ) at the output of the switch (12) are near-direct currents, amplified by two identical direct-current amplifiers.
